# EUROPEAN PATENT APPLICATION

(11) **EP 4 712 206 A1**
(43) Date of publication of application: **18.03.2026**
(21) Application number: 25199355.6
(22) Date of filing: 01.09.2025
(51) Int. Cl.: H01M 10/48

(54) **SYSTEM AND METHOD FOR PREVENTING REUSE OF BMS**

(30) Priority: 12.09.2024 KR 20240125145
(71) Applicant: SAMSUNG SDI CO., LTD., Yongin-si, Gyeonggi-do 17084 (KR)
(72) Inventor: PARK, Jong Sam, 17084 Yongin-si (KR); CHO, Young Shin, 17084 Yongin-si (KR); KANG, Kyungdo, 17084 Yongin-si (KR)
(74) Representative: Maiwald GmbH

(57) **Abstract**

Disclosed are a system and method for preventing the reuse of a battery monitoring system (BMS) and a system and method for preventing an unauthenticated private company from reusing a BMS only when a cell is replaced in a battery pack. The system for preventing the reuse of a BMS includes a battery monitoring unit configured to monitor specifications of a battery, a cell replacement determination unit configured to determine whether a cell has been replaced in a battery pack based on results of the monitoring of the specifications of the battery, and a permanent failure mode entry unit configured to determine whether to enter a permanent failure mode for the battery pack based on the results of the determination of whether the cell has been replaced.

## Description

### BACKGROUND

### 1. Technical Field

The present disclosure relates to a system and method for preventing the reuse of a battery monitoring system (BMS), and more particularly, to a system and method for preventing an unauthenticated private company from reusing a BMS only when a cell is replaced in a battery pack.

### 2. Related Art

In a group of products, such as a vacuum cleaner, a mobile phone, and a laptop, a counterfeit battery not a genuine battery is frequently purchased and used because the price of the counterfeit battery is cheaper. A counterfeit battery has problems in that the counterfeit battery may not be compatible with a system normally and has low reliability even in a protection operation aspect.

In order to reduce the use of a counterfeit battery and provide a safe battery use environment, products into which a genuine authentication function has been introduced are used. In order to pass the genuine authentication function, a private company frequently avoids the genuine authentication function in a way to reuse a battery monitoring system (BMS) of a battery pack and replace only a cell.

If only a cell is replaced and a BMS is reused in a battery pack, there is a problem in that the cell is replaced with a cheap cell having low quality. Furthermore, there is a problem in that a danger of an accident, such as smoking or firing while using a product, because welding/soldering is not performed normally between the cell and the BMS.

### SUMMARY

Embodiments of the present disclosure are directed to providing a system and method for preventing the reuse of a BMS, which determine whether a cell has been replaced through an abnormal path based on cell data stored in the BMS after a battery pack wakes up and prevent the battery pack from being permanently reused.

A system for preventing the reuse of a BMS according to embodiments of the present disclosure may include a battery monitoring unit configured to monitor specifications of a battery, a cell replacement determination unit configured to determine whether a cell has been replaced in a battery pack based on the results of the monitoring of the specifications of the battery, and a permanent failure mode entry unit configured to determine whether to enter a permanent failure mode for the battery pack based on the results of the determination of whether the cell has been replaced.

The battery monitoring unit may monitor the specifications of the battery including at least any one of the capacity and internal resistance of the battery upon wake-up of the battery pack after shutdown.

The cell replacement determination unit may determine that the cell has been replaced when the capacity of the battery is changed into a maximum reference capacity or more or less than the maximum reference capacity.

The cell replacement determination unit may determine that the cell has been replaced when the internal resistance is changed into maximum reference resistance or more or less than the maximum reference resistance.

The cell replacement determination unit may determine that the cell has been replaced when the capacity of the battery is increased to a reference capacity or more and the internal resistance is increased to reference resistance or more.

The cell replacement determination unit may determine that the cell has been replaced when the capacity of the battery is decreased to a reference capacity or more and the internal resistance is decreased to a reference resistance or more.

The cell replacement determination unit may identify an exception condition on the determination of whether the cell has been replaced and prohibits entry into the permanent failure mode, when receiving a communication command related to a reuse of a BMS of the battery pack from a battery pack manufacturer through communication means.

A method of preventing the reuse of a BMS according to embodiments of the present disclosure may include steps of (a) monitoring specifications of a battery, (b) determining whether a cell has been replaced in a battery pack based on the results of the monitoring in the step (a), and (c) determining to enter a permanent failure mode based on the results of the determination of whether the cell has been replaced.

The step (a) may include monitoring the specifications of the battery including at least any one of a capacity and internal resistance of the battery.

The step (b) may include determining that the cell has been replaced when a capacity of the battery, among the specifications of the battery, is changed into a maximum reference capacity or more or less than the maximum reference capacity.

The step (b) may include determining that the cell has been replaced when internal resistance of the battery, among the specifications of the battery, is changed into maximum reference resistance or more or less than the maximum reference resistance.

The step (b) may include determining that the cell has been replaced when a capacity of the battery, among the specifications of the battery, is increased to a reference capacity or more and internal resistance of the battery, among the specifications of the battery, is increased to reference resistance or more.

The step (b) may include determining that the cell has been replaced when a capacity of the battery, among the specifications of the battery, is decreased to a reference capacity or more and internal resistance of the battery, among the specifications of the battery, is decreased to reference resistance or more.

The step (c) may include identifying whether an exception condition on the determination of whether the cell has been replaced is satisfied based on at least any one of a cycle count and a runtime and prohibiting the entry into a permanent failure mode.

An apparatus for preventing the reuse of a BMS according to embodiments of the present disclosure may include an input interface device configured to receive information on the specifications of a battery including at least any one of a capacity and internal resistance of the battery, memory in which a program that may determine a fact that a cell has been replaced by an unauthorized institute based on the information on the specifications of the battery has been stored, and a processor configured to execute the program. The processor may determine the fact that the cell has been replaced based on at least any one reference, including a maximum reference capacity, a reference capacity, maximum reference resistance, and reference resistance.

The processor may determine the fact that the cell has been replaced when the capacity of the battery is changed into the maximum reference capacity or more or less than the maximum reference capacity.

The processor may determine the fact that the cell has been replaced when the internal resistance of the battery is changed into the maximum reference resistance or more or less than the maximum reference resistance.

The processor may determine the fact that the cell has been replaced when the capacity of the battery is increased to the reference capacity or more and the internal resistance of the battery is increased to the reference resistance or more.

The processor may determine the fact that the cell has been replaced when the capacity of the battery is decreased to the reference capacity or more and the internal resistance of the battery is decreased to the reference resistance or more.

The processor may determine to enter a permanent failure mode based on the results of the determination of the fact that the cell has been replaced, and identifies an entry exception condition on the permanent failure mode by identifying a communication command received from a pack manufacturer.

According to the embodiments of the present disclosure, it is possible to prevent a situation in which a problem occurs in the safety of a battery by entering the permanent failure mode, if a situation in which a cell has been replaced in a battery pack and the setting of the cell is not compatible with a protection operation of the BMS of the battery pack, such as a case in which a cell has been replaced with a cell the current of which has been permitted up to only 10 A wherein over-current protection for the BMS is set 15 A, for example, is identified.

According to the embodiments of the present disclosure, it is possible to contribute to a company management aspect by inducing the use of a battery pack that is developed by a manufacturer, by allowing the BMS of the battery pack to be reused only in the manufacturer or a company authorized by the manufacturer.

### BRIEF DESCRIPTION OF THE DRAWINGS

The following drawings illustrate example embodiments of the present disclosure, and further describe example aspects of the present disclosure together with the detailed description of the present disclosure. Thus, the present disclosure should not be construed as being limited to the drawings:
FIG. 1 schematically illustrates an electrode assembly of a secondary battery;
FIG. 2 schematically illustrates a configuration of a pouch-type secondary battery;
FIG. 3 illustrates a schematic external appearance configuration of a prismatic secondary battery;
FIG. 4 is a cross-sectional view of a cylindrical secondary battery;
FIG. 5 illustrates a construction of a system for preventing the reuse of a BMS according to embodiments of the present disclosure.
FIG. 6 illustrates a method of preventing the reuse of a BMS according to embodiments of the present disclosure.
FIG. 7 illustrates a detailed sequence of a method of preventing the reuse of a BMS according to embodiments of the present disclosure.
FIG. 8 is a block diagram illustrating a computer system for implementing a method according to another embodiment of the present disclosure.
FIG. 9 is an example view of a secondary battery module in which secondary batteries manufactured according to examples of the present disclosure are arranged;
FIG. 10 is an example view of a secondary battery pack including the secondary battery module illustrated in FIG. 10; and
FIG. 11 is a conceptual view of a vehicle including the secondary battery pack illustrated in FIG. 10.

### Detailed description

Hereinafter, example embodiments of the present disclosure will be described, in detail, with reference to the accompanying drawings. The terms or words used in the present specification and claims are not to be limitedly interpreted based on their general or ordinary meaning, and should be interpreted as meanings and concepts that are consistent with the technical idea of the present disclosure on the basis of the principle that an inventor can be their own lexicographer to appropriately define concepts of terms to describe their invention in the best way.

The example embodiments described in this specification and the configurations shown in the drawings are only some example embodiments of the present disclosure and do not represent all of the aspects of the present disclosure. Accordingly, it should be understood that there may be various equivalents and modifications that can replace or modify one or more example embodiments described herein at the time of filing this application.

It will be understood that if an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, if a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges is within the scope of this invention.

References to two compared elements, features, etc. As being "the same" may mean that they are "substantially the same." Thus, the phrase "substantially the same" may include a case having a deviation that is considered low in the art, for example, a deviation of 5% or less. In addition, if a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may contact the upper (or lower) surface of the element, and another element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components."

Throughout the specification, if "A and/or B" is stated, it means A, B or A and B, unless otherwise stated. That is, "and/or" includes any or all combinations of a plurality of items enumerated. When "C to D" is stated, it means C or more and D or less, unless otherwise specified.

When the terms "about" or "substantially" are used in this specification in connection with a numerical value, it is intended that the associated numerical value include a tolerance of ±10% around the stated numerical value. When ranges are specified, the range includes all values therebetween such as increments of 0.1%.

The terminology used herein is for the purpose of describing example embodiments of the present disclosure and is not intended to limit the present disclosure.

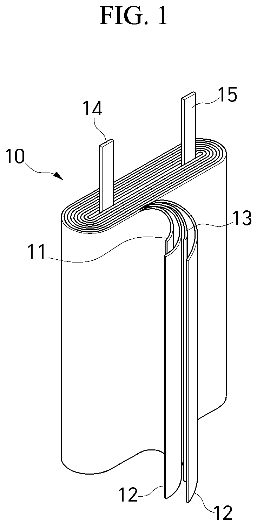

FIG. 1 schematically illustrates an electrode assembly built in a case of a secondary battery.

An electrode assembly 10 may be formed by winding or stacking a stack of a first electrode plate 11, a separator 12, and a second electrode plate 13, which are formed as thin plates or films. When the electrode assembly 10 is a wound stack, a winding axis may be parallel to the longitudinal direction (e.g., the y direction) of the case 59. In other example embodiments, the electrode assembly 10 may be a stack type rather than a winding type, and the shape of the electrode assembly 10 is not limited in the examples of the present disclosure. In addition, the electrode assembly 10 may be or include a Z-stack electrode assembly in which a positive electrode plate and a negative electrode plate are inserted into both sides of a separator, which is then bent into a Z-stack. In addition, one or more electrode assemblies may be stacked such that long sides of the electrode assemblies are adjacent to each other and accommodated in the case, and the number of electrode assemblies in the case is not limited in the examples of the present disclosure. The first electrode plate 11 of the electrode assembly may act as a negative electrode, and the second electrode plate 13 may act as a positive electrode. In examples, the reverse is also possible.

The first electrode plate 11 may be formed by applying a first electrode active material, such as graphite or carbon, to a first electrode current collector formed of a metal foil, such as copper, a copper alloy, nickel, or a nickel alloy. The first electrode tab 14 may be connected to an external first terminal (not shown). In some example embodiments, when the first electrode plate 11 is manufactured, the first electrode tab 14 may be formed by being cut in advance to protrude to one side of the electrode assembly 10, or the first electrode tab 14 may protrude to one side of the electrode assembly 10 more than, e.g., farther than or beyond, the separator 12 without being separately cut.

The second electrode plate 13 may be formed by applying a second electrode active material, such as a transition metal oxide, on a second electrode current collector formed of or including a metal foil, such as aluminum or an aluminum alloy. The second electrode plate 13 may include a second electrode tab 15 (e.g., a second uncoated portion) that is or includes a region to which the second electrode active material is not applied. The second electrode tab 15 may be connected to an external second terminal (not shown). In some example embodiments, the second electrode tab 15 may be formed by being cut in advance to protrude to the other side (e.g., the opposite side) of the electrode assembly 10 when the second electrode plate 13 is manufactured, or the second electrode plate 13 may protrude to the other side of the electrode assembly more than, e.g., farther than or beyond, the separator 12 without being separately cut.

In some example embodiments, the first electrode tab 14 may be located on the left side of the electrode assembly 10, and the second electrode tab 15 may be located on the right side of the electrode assembly 10. In other example embodiments, the first electrode tab 14 and the second electrode tab 15 may be located on one side of the electrode assembly 10 in the same direction.

Here, for convenience of description, the left and right sides are defined according to the electrode assembly 10 as oriented in FIG. 1, and the positions thereof may change when the secondary battery is rotated left and right or up and down.

The separator 12 hinders or substantially prevents a short-circuit between the first electrode 11 and the second electrode 13 while allowing movement of lithium ions therebetween. The separator 12 may be made of or include, for example, a polyethylene film, a polypropylene film, a polyethylene-polypropylene film, etc.

In some example embodiments, the electrode assembly 10 may be accommodated in the case (not shown) along with an electrolyte. In the case of a pouch-type secondary battery, an electrode assembly 10 may be accommodated in a pouch made of or including flexible material in the form illustrated in FIG. 1. In the case of a prismatic secondary battery, an electrode assembly 10 may be accommodated in a prismatic metal casing in the form illustrated in FIG. 1.

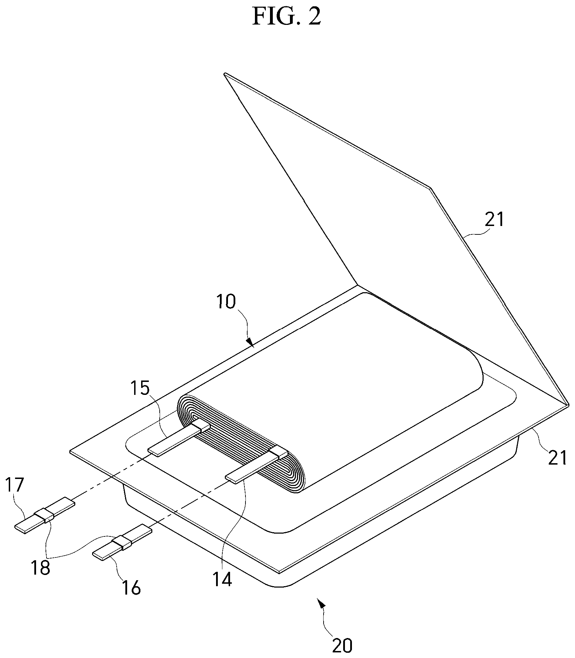

FIG. 2 schematically illustrates the pouch-type secondary battery.

The pouch-type secondary battery includes an electrode assembly 10 and a pouch 20 that accommodates or contains the electrode assembly 10 therein.

The electrode assembly 10 may be the same as the electrode assembly 10 illustrated in FIG. 1. The first electrode tab 14 and the second electrode tab 15 of the electrode assembly 10 may be electrically connected to respective external first and second terminal leads 16 and 17 by e.g., welding or other attaching method that preserves conductivity therebetween. At least a portion of each of the first terminal lead 16 and the second terminal lead 17 may be attached or covered with a tab film 18 for insulation from the pouch 20.

The pouch 20 may be sealed by having sealing parts 21 at the edges thereof come into contact with each other while accommodating or containing the electrode assembly 10 therein, in which case the sealing may be achieved with the tab film 18 interposed between the sealing parts 21. The sealing parts 21 of the pouch 20 may be made of or include a thermal fusion material that generally has weak adhesion to metal. Thus, it may be fused to the pouch 20 by interposing the thin tab film 18 between the sealing parts 21.

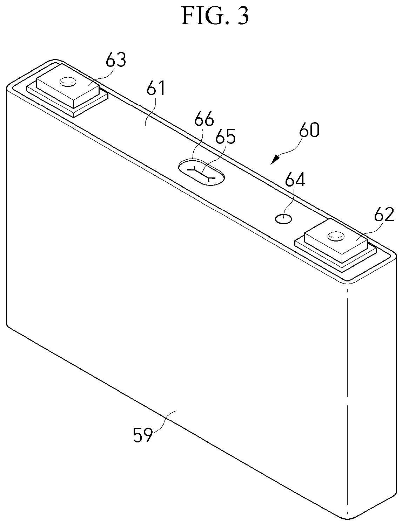

FIG. 3 illustrates a schematic external appearance configuration of a prismatic secondary battery.

A prismatic case 59 defines an overall appearance of the prismatic secondary battery, and may be made of or include a conductive metal, such as aluminum, aluminum alloy, or nickel-plated steel. In addition, the case 59 may provide a space for accommodating or containing the electrode assembly 10 therein.

A cap assembly 60 may include a cap plate 61 that covers an opening of the case 59, and the case 59 and the cap plate 61 may be made of or include a conductive material. A first terminal 63 and a second terminal 62 may be electrically connected to the first electrode tab 14 and the second electrode tab 15 of the electrode assembly 10 illustrated in FIGS. 1 and 2 inside the case 59, and may be installed to protrude outward through the cap plate 61.

The cap plate 61 may be equipped with or include an electrolyte injection port 64 configured to install a sealing plug therein, and a vent 66 formed that includes a notch 65 may be installed. The vent 66 is configured to discharge any gas generated inside the secondary battery.

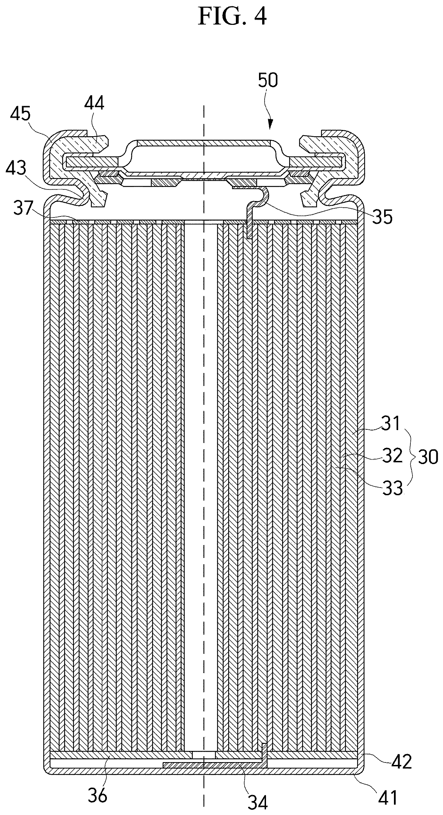

FIG. 4 is a cross-sectional view of a cylindrical secondary battery.

The cylindrical secondary battery includes an electrode assembly 30, a case accommodating the electrode assembly 30 and an electrolyte therein, a cap assembly 50 coupled to an opening of the case to seal the case, and an insulating plate 37 located between the electrode assembly 30 and the cap assembly 50 inside the case.

The electrode assembly 30 may include a separator 32 between a first electrode 33 and a second electrode 31, and the electrode assembly 30 may be wound in a jelly-roll form.

The first electrode 33 may include a first substrate and a first active material layer located on the first substrate. A first lead tab 35 may extend outward from a first uncoated portion of the first substrate where the first active material layer is not located, and may be electrically connected to the cap assembly 50.

The second electrode 31 may include a second substrate and a second active material layer located on the second substrate. A second lead tab 34 may extend outward from a second uncoated portion of the second substrate where the second active material layer is not located, and may be electrically connected to the case. The first lead tab 35 and the second lead tab 34 may extend in opposite directions with respect to each other.

The first electrode 33 may constitute a positive electrode. In this case, the first substrate may be composed of or include, for example, aluminum foil, and the first active material layer may include, for example, a transition metal oxide. The second electrode 31 may constitute a negative electrode. In this case, the second substrate may be composed of or include, for example, copper foil or nickel foil, and the second active material layer may include, for example, graphite.

The separator 32 may reduce or prevent a short-circuit between the first electrode 33 and the second electrode 31 while allowing movement of lithium ions therebetween. The separator 32 may be made of or include, for example, at least one of a polyethylene film, a polypropylene film, a polyethylene-polypropylene film, etc.

The case accommodates or contains the electrode assembly 30 and the electrolyte, and substantially forms the external appearance of the secondary battery together with the cap assembly 50. The case may have a substantially cylindrical body portion 42, and a bottom portion 41 connected to one side of the body portion 42. A beading part 43 deformed inwardly may be formed in the body portion 42, and a crimping part 45 bent inwardly may be formed at an open end of the body portion 42.

The beading part 43 may reduce or prevent movement of the electrode assembly 30 inside the case, and may facilitate seating of a gasket 44 and the cap assembly 50. A crimping part 45 may firmly fix the cap assembly 50 by pressing the edge of the cap assembly 50 against the gasket 44. The case may be formed of or include iron plated with nickel, for example.

The cap assembly 50 may be fixed to the inside of the crimping part 45 through the gasket 44 to seal the case. The cap assembly 50 may include a cap up, a safety vent, a cap down, an insulating member, and a subplate, but is not limited to this example and may be variously modified.

The cap up may be located at the very top of the cap assembly 50. The cap up may include a terminal portion that protrudes convexly upward and is connected to an external circuit, and an outlet for discharging gas may be located around the terminal portion.

The safety vent may be located below the cap up. The safety vent may include a protrusion that protrudes convexly downward and is connected to the subplate, and at least one notch located around the protrusion.

When gas is generated due to overcharging or abnormal operation of the secondary battery, the protrusion may be deformed upward by pressure and may separate from the subplate, while the safety vent may be cut along the notch. The cut safety vent may hinder or prevent the secondary battery from exploding by discharging gas to the outside.

The cap down may be located below the safety vent. The cap down may be formed with a first opening for exposing the protrusion of the safety vent and a second opening for discharging gas. The insulating member may be located between the safety vent and the cap down to insulate the safety vent and the cap down.

The subplate may be located below the cap down. The subplate may be fixed to a lower surface of the cap down to block the first opening of the cap down, and the protrusion of the safety vent may be fixed to the subplate. The first lead tab 35 pulled out from the electrode assembly 30 may be fixed to the subplate. Accordingly, the cap up, the safety vent, the cap down, and the subplate may be electrically connected to the first electrode 33 of the electrode assembly 30.

The insulating plate 37 may be located below the beading part 43 to be in contact with the electrode assembly 30, and may be provided with a tab opening for pulling out the first lead tab 35. The cap assembly 50, which is electrically connected to the first electrode 33 by the first lead tab 35, may face the electrode assembly 30 with the insulating plate 37 interposed therebetween, and may maintain an insulated state from the electrode assembly 30 by the insulating plate 37. On the other hand, another insulating plate 36 may be included for insulation between the electrode assembly 30 and the bottom portion 41 of the case.

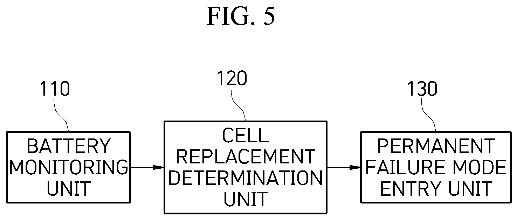

Hereinafter, a system and method for preventing the reuse of a BMS according to embodiments of the present disclosure are described with reference to FIGS. 5 to 8.

As described above, if a cell is replaced in a battery pack by an unauthorized private company and the BMS of the battery pack is reused, there is a problem in the safety aspect. When a cell is replaced while a battery pack operates, the battery pack may naturally enter a permanent failure mode because a cell imbalance or a low voltage failure is detected. In contrast, if only a cell is replaced in a battery back in the state in which the battery pack has been shut down, there is a problem in that it is not easy to find out the fact that the cell has been replaced.

According to embodiments of the present disclosure, it is possible to prevent a problem, such as smoking or firing, by preventing a battery pack from being permanently used, in a way to determine whether a cell has been replaced through an abnormal path by analyzing cell data stored in the BMS of the battery pack after the battery pack wakes up and to enter the permanent failure mode when it is determined that the cell has been replaced through the abnormal path by an unauthorized private company.

According to embodiments of the present disclosure, the intended reuse of a battery pack of a BMS thereof is controlled to avoid entering the permanent failure mode by putting an exception condition on a determination of whether a cell has been replaced if a cell is replaced for the purpose of the reuse of the BMS of a battery pack in an authenticated institute or tests are performed during development in a manufacturer.

FIG. 5 illustrates a construction of a system for preventing the reuse of a BMS according to embodiments of the present disclosure.

According to embodiments of the present disclosure, whether a cell of a battery has been replaced may be determined by monitoring the specifications of the battery for at least any one of the capacity and internal resistance of the battery. If the capacity of a battery is monitored, it may be determined that a cell has been replaced if the capacity of the battery has been changed into a maximum reference capacity or more or less than the maximum reference capacity. If the internal resistance of the battery is monitored, it may be determined that a cell has been replaced if the internal resistance has been changed into a maximum reference resistance or more or less than the maximum reference resistance. Furthermore, if the capacity of the battery is changed into a reference capacity or more or less than the reference capacity and the internal resistance of the battery is changed into a reference capacity or more or less than the reference capacity, it may be determined that the cell has been replaced.

The system for preventing the reuse of a BMS according to embodiments of the present disclosure may include a battery monitoring unit 110 that monitors the specifications of a battery, a cell replacement determination unit 120 that determines whether a cell has been replaced in a battery pack based on the results of the monitoring of the specifications of the battery, and a permanent failure mode entry unit 130 that enters the permanent failure mode if the cell has been replaced by an unauthorized institute.

The capacity of a battery may be decreased as a cell is degraded, and internal resistance of the cell may be increased as the capacity of the cell is decreased. Although an event to replace a cell in a battery pack is not present, it may be sensed that the capacity of a battery has been increased or internal resistance of the cell has been decreased due to a measuring error or use environment (e.g., a temperature) of the BMS of the battery pack.

When a cell of a battery is replaced and a battery pack is woken up in the state in which the battery pack has been shut down, the BMS of the battery pack cannot identify whether the cell has been replaced. In contrast, according to embodiments of the present disclosure, the BMS of a battery pack may determine whether a cell of a battery has been replaced by monitoring the specifications of the battery for at least any one of the capacity and internal resistance of the battery, which are sensed as the battery performs charging or discharging. Accordingly, the battery monitoring unit 110 may monitor the specifications of the battery including at least any one of the capacity and internal resistance of the battery. The cell replacement determination unit 120 may analyze the results of the monitoring of the specifications of the battery based on at least any one of a reference capacity and reference resistance, and may determine whether the cell has been replaced.

In order to prevent false detection for whether a cell has been replaced, the cell replacement determination unit 120 may perform a determination of whether the cell has been replaced from wake-up timing up to only timing at which the capacity of a battery is updated, and may not perform a determination of whether the cell has been replaced from timing at which the capacity has been updated. Hereinafter, an exception condition related to a determination of whether a cell has been replaced for preventing false detection is first described, and a criterion for a determination of whether a cell has been replaced is then described.

The cell replacement determination unit 120 does not perform a determination of whether a cell has been replaced when a timing at which a battery pack is manufactured does not exceed a battery warranty period because the timing has not passed a reference period. For example, when a cycle count is equal to or less than a reference (e.g., 50 cycles), the cell replacement determination unit 120 does not enter the permanent failure mode. The cell replacement determination unit 120 does not enter the permanent failure mode when a run time is equal to or less than a reference (e.g., 180 days).

The cell replacement determination unit 120 may receive a communication command generated by a battery pack manufacturer and may not enter the permanent failure mode by identifying the communication command, if a BMS is intended to be reused, that is, the BMS is intentionally reused by an authenticated institute or tests are performed on the BMS for reuse. The communication command may not be public to the outside, and is used to identify that an exception condition related to a determination of whether a cell has been replaced is satisfied only when a key value is matched. Such a key value is a pre-ordered value, and may be information that is known to only a pack manufacturer.

The cell replacement determination unit 120 may determine that a cell has been replaced in a battery pack when a criterion for a determination of whether the cell has been replaced. The permanent failure mode entry unit 130 may enter the permanent failure mode for a battery pack based on a determination of the replacement of the cell replacement determination unit 120 unless an exception condition related to the determination of whether the cell has been replaced is satisfied.

The cell replacement determination unit 120 may determine that a cell has been replaced in a battery pack when the capacity of a battery is changed into a maximum reference capacity or more or less than the maximum reference capacity. The cell replacement determination unit 120 may determine that a cell has been replaced when the sensed capacity of a battery is increased to a maximum reference capacity (e.g., 1000 mAh) or more, that is, when the capacity of the battery is increased to 1500 mAh after the wake-up of the battery pack, compared to the capacity of the battery at timing at which a battery pack is shut down. The permanent failure mode entry unit 130 may enter the permanent failure mode based on the results of the determination of the cell replacement determination unit 120 as the capacity of the battery is increased to the maximum reference capacity or more.

The cell replacement determination unit 120 may determine that a cell has been replaced in a battery pack when internal resistance of the cell is changed into a maximum reference resistance or more or less than the maximum reference resistance. The cell replacement determination unit 120 may determine that a cell has been replaced when sensed internal resistance of the cell is decreased to maximum reference resistance (e.g., 10 milliohm) or more, that is, when the internal resistance of the cell is decreased to 10 milliohm after the wake-up of a battery pack, compared to internal resistance of the cell at timing at which the battery pack is shut down. The permanent failure mode entry unit 130 may enter the permanent failure mode based on the results of the determination of the cell replacement determination unit 120 as the internal resistance of the cell is decreased to the maximum reference resistance or more.

The cell replacement determination unit 120 may determine that a cell has been replaced in a battery pack when the capacity of a battery is increased to a reference capacity or more and internal resistance of the cell is increased to reference resistance or more. The cell replacement determination unit 120 may determine that a cell has been replaced when the capacity of a battery is increased to a reference capacity (e.g., 300 mAh) or more and the internal resistance of the cell is increased to reference resistance (e.g., 1 milliohm) or more after the wake-up of a battery pack, that is, when the capacity of the battery is increased to 400 mAh and the internal resistance of the cell is increased to 1.3 milliohm without being decreased after the wake-up, compared to timing at which the battery pack is shut down.

The cell replacement determination unit 120 may determine that a cell has been replaced in a battery pack when the capacity of a battery is decreased to a reference capacity or more and internal resistance of the cell is decreased to reference resistance or more. The cell replacement determination unit 120 may determine that a cell has been replaced when the capacity of a battery is increased to a reference capacity (e.g., 300 mAh) or more and the internal resistance of the cell is decreased to reference resistance (e.g., 1 milliohm) or more after the wake-up of a battery pack, that is, the capacity of the battery is decreased to 400 mAh, but the internal resistance of the cell is decreased to 1.3 milliohm without being increased after the wake-up, compared to timing at which the battery pack is shut down.

According to embodiments of the present disclosure, in the case of the same type of cell, an internal resistance value of a battery is increased as the deterioration of the cell becomes worse. In the case of different types of cells, whether a cell has been replaced in a battery pack may be determined by considering a maximum reference capacity, maximum reference resistance, a reference capacity, and reference resistance because the capacities and resistance of the cells cannot be compared as an absolute numerical value.

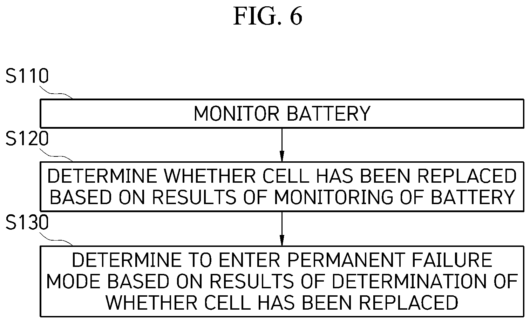

FIG. 6 illustrates a method of preventing the reuse of a BMS according to embodiments of the present disclosure.

The method of preventing the reuse of a BMS according to embodiments of the present disclosure may include step S110 of monitoring the specifications of a battery, step S120 of determining whether a cell has been replaced in a battery pack based on the results of the monitoring of the specifications of the battery in step S110, and step S130 of entering the permanent failure mode based on the results of the determination of whether the cell has been replaced.

In step S110, the specifications of a battery including at least any one of the capacity of the battery and internal resistance of a cell thereof may be monitored. In step S120, the results of the monitoring of the specifications of the battery and whether the cell has been replaced may be determined based on at least any one of a maximum reference capacity, maximum reference resistance, a reference capacity, and reference resistance.

In step S120, in order to prevent false detection for whether the cell has been replaced, the determination of whether the cell has been replaced may be performed from wake-up timing to timing at which the capacity of the battery is updated, and may not be performed from the timing the capacity is updated. In step S120, if a battery warranty period is not exceeded because it is not long after a battery pack was fabricated, the determination of whether the cell has been replaced may not be performed, and the permanent failure mode may not be entered. When a cycle count is equal to or smaller than a reference (e.g., 50 cycles) or when a run time is equal to or smaller than a reference (e.g., 180 days), the determination of whether the cell has been replaced may not be performed, and the permanent failure mode may not be entered.

In step S120, an exception situation in which the permanent failure mode is not entered may be determined by receiving and identifying a communication command generated by a battery pack manufacturer in order for a BMS to be intentionally reused by an authenticated institute or for the purpose of performing tests during development. The communication command is information that is known to only a manufacturer and may not public to the outside. It is identified that an exception condition related to the determination of whether the cell has been replaced is satisfied only when a key value is matched.

In step S120, whether the cell has been replaced in the battery pack may be determined based on a criterion for the determination of whether the cell has been replaced. In step S130, the battery pack may be made to enter the permanent failure mode based on the results of the determination in step S120 unless the exception condition (e.g., when the reuse of the BMS is intentionally used by a manufacturer) related to the determination of whether the cell has been replaced is satisfied.

In step S120, when the capacity of the battery is increased to a maximum reference capacity or more, it may be determined that the cell has been replaced in the battery pack. It may be determined that the cell has been replaced when the sensed capacity of the battery is increased to a maximum reference capacity (e.g., 1000 mAh) or more, that is, when the capacity of the battery is increased to 1500 mAh after the wake-up of the battery pack, compared to the capacity of the battery at timing at which the battery pack is shut down. In step S130, the permanent failure mode may be entered based the results of the determination of whether the cell has been replaced according to the increase of the capacity of the battery to the maximum reference capacity or more in step S120.

In step S120, when internal resistance of the cell is decreased to maximum reference resistance or more, it may be determined that the cell has been replaced in the battery pack. It may be determined that the cell has been replaced when sensed internal resistance of the cell is decreased to maximum reference resistance (e.g., 10 milliohm) or more, that is, when the internal resistance of the cell is decreased to 10 milliohm after the wake-up of the battery pack, compared to internal resistance of the cell at timing at which the battery pack is shut down. In step S130, the permanent failure mode may be entered based on the results of the determination of whether the cell has been replaced according to the decrease of the internal resistance of the cell to the maximum reference resistance or more in step S120.

In step S120, it may be determined that the cell has been replaced in the battery pack when the capacity of the battery is increased to a reference capacity or more and internal resistance of the cell is increased to reference resistance or more. It may be determined that the cell has been replaced when the capacity of the battery is increased to a reference capacity (e.g., 300 mAh) or more and the internal resistance of the cell is increased to reference resistance (e.g., 1 milliohm) or more after the wake-up of the battery pack, that is, when the capacity of the battery is increased to 400 mAh and the internal resistance of the cell is increased to 1.3 milliohm without being decreased after the wake-up, compared to timing at which the battery pack is shut down. In step S130, the permanent failure mode may be entered based on the results of the determination of whether the cell has been replaced according to the increase of the capacity of the battery to the reference capacity or more and the increase of the internal resistance of the cell to the reference resistance or more in step S120.

In step S120, it may be determined that the cell has been replaced in the battery pack when the capacity of the battery is decreased to a reference capacity or more and internal resistance of the cell is decreased to reference resistance or more. It may be determined that the cell has been replaced when the capacity of the battery is increased to a reference capacity (e.g., 300 mAh) or more and the internal resistance of the cell is decreased to reference resistance (e.g., 1 milliohm) or more after the wake-up of the battery pack, that is, the capacity of the battery is decreased to 400 mAh, but the internal resistance of the cell is decreased to 1.3 milliohm without being increased after the wake-up, compared to timing at which the battery pack is shut down. In step S130, the permanent failure mode may be entered based on the results of the determination of whether the cell has been replaced according to the decrease of the capacity of the battery to the reference capacity or more and the decrease of the internal resistance of the cell to the reference resistance or more in step S120.

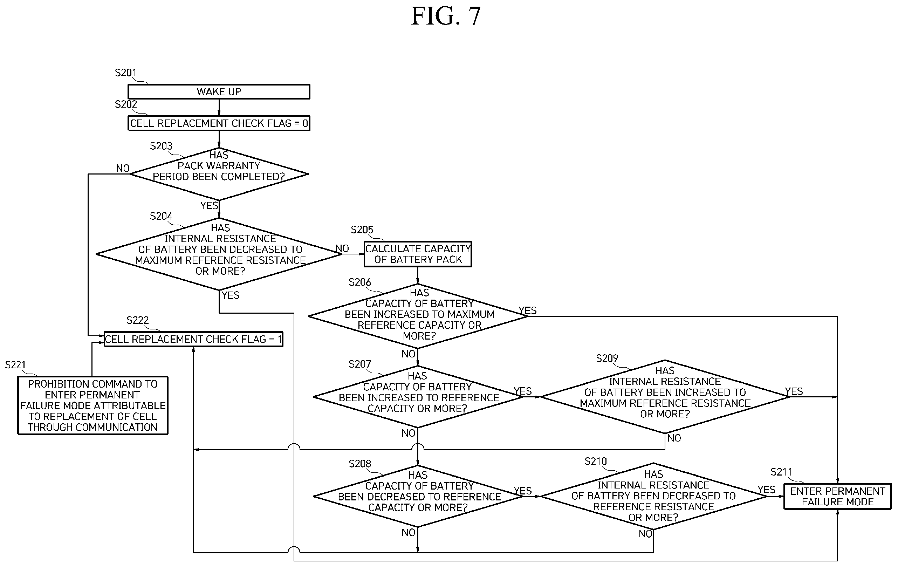

FIG. 7 illustrates a detailed sequence of a method of preventing the reuse of a BMS according to embodiments of the present disclosure.

**In** step S201, a battery pack may wake up.

**In** step S202, a cell replacement check flag may be checked as 0.

**In** step S203, it may be identified whether a pack warranty period has been completed. In order to prevent false detection for whether a cell has been replaced, when the battery warranty period is not exceeded because it is not long after the battery pack was fabricated, a determination of whether the cell has been replaced may not be performed, and the cell replacement check flag may be checked as 1 in step S222. In step S203, whether a cycle count is equal to or smaller than a reference (e.g., 50 cycles) may be checked. Alternatively, in step S203, whether a runtime is equal to or smaller than a reference to (e.g., 180 days) may be checked.

As an exception condition related to the determination of whether the cell has been replaced, when a permanent failure mode entry prohibition command attributable to the replacement of the cell is received through communication, in step S221, the cell replacement check flag may be checked as 1, and the permanent failure mode may not be entered. That is, if a BMS is intentionally reused by an authenticated institute or tests are performed on the BMS during development, the permanent failure mode may not be entered by receiving a communication command generated by a battery pack manufacturer.

When it is identified that the pack warranty period has been completed in step S203, it is identified whether internal resistance of the battery has been changed into maximum reference resistance or more or less than the maximum reference resistance in step S204 (FIG. 7 illustrates that whether internal resistance of the battery has been decreased to maximum reference resistance or less is identified).

When it is identified that the internal resistance of the battery has been decreased to the maximum reference resistance or more in step S204, it may be determined that the cell has been replaced in the battery pack. In step S211, the permanent failure mode may be entered. It may be determined that the cell has been replaced when sensed internal resistance of the cell is decreased to maximum reference resistance (e.g., 10 milliohm) or more, that is, when the internal resistance of the cell is decreased to 10 milliohm after the wake-up of the battery pack, compared to internal resistance of the cell at timing at which the battery pack is shut down, the permanent failure mode may be entered.

When it is identified that the internal resistance of the battery has not been decreased to the maximum reference resistance or more in step S204, the calculation of a pack capacity may be performed in step S205.

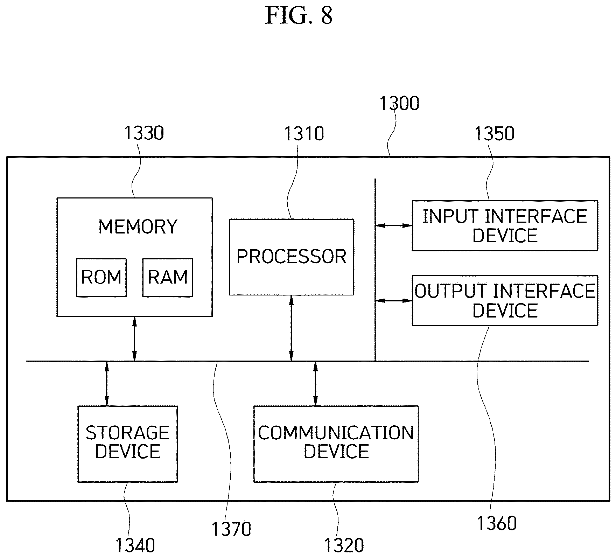

In step S206, it is identified whether the capacity of the battery pack has been changed into a maximum reference capacity or more or less (FIG. 8 illustrates whether the capacity of the battery pack has been increased to a maximum reference capacity or more).

When it is identified that the capacity of the battery pack has been increased to the maximum reference capacity or more in step S206, the permanent failure mode may be entered in step S211. It may be determined that the cell has been replaced when the sensed capacity of the battery is increased to a maximum reference capacity (e.g., 1000 mAh) or more, that is, when the capacity of the battery is increased to 1500 mAh after the wake-up of the battery pack, compared to the capacity of the battery at timing at which the battery pack is shut down, and the permanent failure mode may be entered.

When it is identified that the capacity of the battery pack has not been increased to the maximum reference capacity or more in step S206, in step S207, it is identified whether the capacity of the battery pack has been increased to a reference capacity or more. When it is identified that the capacity of the battery pack has been increased to the reference capacity or more in step S207, whether internal resistance of the battery has been increased to the reference resistance or more is identified in step S209.

That is, when it is identified that the capacity of the battery has been increased to the reference capacity or more and the internal resistance of the battery has been increased to the reference resistance or more, in step S211, the permanent failure mode may be entered. It may be determined that the cell has been replaced when the capacity of the battery is increased to a reference capacity (e.g., 300 mAh) or more and the internal resistance of the cell is increased to reference resistance (e.g., 1 milliohm) or more after the wake-up of the battery pack, that is, when the capacity of the battery is increased to 400 mAh and the internal resistance of the cell is increased to 1.3 milliohm without being decreased after the wake-up, compared to timing at which the battery pack is shut down, and the permanent failure mode may be entered.

When it is identified that the capacity of the battery pack has not been increased to the reference capacity or more in step S207, whether the capacity of the battery pack has been decreased to the reference capacity or more is identified in step S208. When it is identified that the capacity of the battery pack has been decreased to the reference capacity or more in step S208, whether the internal resistance of the battery has been decreased to the reference resistance or more is identified in step S210.

That is, when it is identified that the capacity of the battery has been decreased to the reference capacity or more and the internal resistance of the battery has been decreased to the reference resistance or more, in step S211, the permanent failure mode may be entered. It may be determined that the cell has been replaced when the capacity of the battery is increased to a reference capacity (e.g., 300 mAh) or more and the internal resistance of the cell is decreased to reference resistance (e.g., 1 milliohm) or more after the wake-up of the battery pack, that is, the capacity of the battery is decreased to 400 mAh, but the internal resistance of the cell is decreased to 1.3 milliohm without being increased after the wake-up, compared to timing at which the battery pack is shut down, and the permanent failure mode may be entered.

FIG. 8 is a block diagram illustrating a computer system for implementing a method according to an example embodiment of the present disclosure.

Referring to FIG. 8, the computer system 1300 may include at least one of a processor 1310, a memory 1330, an input interface device 1350, an output interface device 1360, and a storage device 1340 communicating with one another through a bus 1370. The computer system 1300 may also include a communication device 1320 coupled to a network. The processor 1310 may be or include a central processing unit (CPU) or a semiconductor device that executes instructions stored in the memory 1330 or in the storage device 1340. The memory 1330 and the storage device 1340 may include various types of volatile or nonvolatile storage media. For example, the memory may include a read-only memory (ROM) and a random access memory (RAM). In example embodiments of the present disclosure, the memory may be located inside or outside the processor, and may be connected to the processor through various known means. The memory is or includes various types of volatile or nonvolatile storage media, and for example, may include a read-only memory (ROM) or a random access memory (RAM).

Accordingly, example embodiments of the present disclosure may be implemented as a method implemented in a computer or a non-transitory computer-readable medium storing computer-executable instructions. In an example embodiment, when executed by the processor, computer-readable instructions may perform a method according to at least one aspect of the present disclosure.

The communication device 1320 may transmit or receive wired signals or wireless signals.

The apparatus for preventing the reuse of a BMS according to embodiments of the present disclosure may include an input interface device 1350 that receives information on the specifications of a battery including at least any one of the capacity and internal resistance of the battery, memory 1330 in which a program that determines the fact that a cell has been replaced by an unauthorized institute has been stored based on the information on the specifications of the battery, and the processor 1310 that execute the program. The processor 1310 may determine the fact that a cell has been replaced based on at least any one of references including a maximum reference capacity, a reference capacity, maximum reference resistance, and reference resistance.

The processor 1310 may determine the fact that a cell has been replaced when the capacity of a battery is changed into a maximum reference capacity or more or less than the maximum reference capacity.

The processor 1310 may determine the fact that a cell has been replaced when internal resistance of the battery is changed into maximum reference resistance or more or less than the maximum reference resistance.

The processor 1310 may determine the fact that the cell has been replaced when the capacity of a battery is increased to a reference capacity or more and internal resistance of the battery is increased to reference resistance or more.

The processor 1310 may determine the fact that a cell has been replaced when the capacity of a battery is decreased to a reference capacity or more and internal resistance of the battery is decreased to reference resistance or more.

The processor 1310 may determine to enter the permanent failure mode based on the results of a determination of the fact that a cell has been replaced, and may identify an entry exception condition on the permanent failure mode by identifying a communication command received from a pack manufacturer.

Additionally, the method according to an example embodiment of the present disclosure may be implemented in the form of program instructions that can be executed through various computer means and recorded on a computer-readable medium.

The computer-readable medium may include program instructions, data files, data structures, etc., singly or in combination. The program instructions recorded on the computer-readable medium may be specially designed and configured for the example embodiments of the present disclosure, or may be known and usable by those skilled in the art of computer software. Computer-readable recording media may include a hardware device configured to store and perform program instructions. For example, the computer-readable recording media may be or include magnetic media such as hard disks, floppy disks, and magnetic tapes, optical media such as CD-ROMs and DVDs, magneto-optical media such as floptical disks, ROM, RAM, flash memory, etc. The program instructions may include not only machine language codes such as that generated by a compiler, but also high-level language codes that can be executed by a computer through an interpreter, etc.

Hereinafter, any material that may be usable for the secondary battery according to examples of the present disclosure will be described.

**As** the positive electrode active material, a compound capable of reversibly intercalating/deintercalating lithium (e.g., a lithiated intercalation compound) may be used. For example, at least one of a composite oxide of lithium and a metal such as at least one of cobalt, manganese, nickel, and combinations thereof may be used.

The composite oxide may be or include a lithium transition metal composite oxide, and examples thereof may include at least one of a lithium nickel-based oxide, a lithium cobalt-based oxide, a lithium manganese-based oxide, a lithium iron phosphate-based compound, a cobalt-free nickel-manganese-based oxide, or a combination thereof.

**As** an example, a compound represented by at least any one of the following formulas may be used: LiₐA_{1-b}X_{b}O_{2-c}D_{c} (0.90≤a≤1.8, 0≤b≤0.5, 0≤c≤0.05) ; LiₐMn_{2-b}X_{b}O_{4-c}D_{c} (0.90≤a≤1 8, 0≤b≤0.5, 0≤c≤0.05); LiₐNi_{1-b-c}Co_{b}X_{c}O_{2-α}D_{α} (0.90≤a≤1.8, 0≤b≤0.5, 0≤c≤0.5, 0<α<2); LiₐNi_{1-b-c}Mn_{b}X_{c}O_{2-α}D_{α} (0.90≤a≤1.8, 0≤b≤0.5, 0≤c≤0.5, 0<α<2); LiₐNi_{b}Co_{c}L¹_{d}GₑO₂ (0.90≤a≤1.8, 0≤b≤0.9, 0≤c≤0.5, 0≤d≤0.5, 0≤e≤0.1); LiₐNiG_{b}O₂ (0.90≤a≤1.8, 0.001≤b≤0.1); LiₐCoG_{b}O₂ (0.90≤a≤1.8, 0.001≤b≤0.1); LiₐMn₁₋ₑGₑO₂ (0.90≤a≤1.8, 0.001≤b≤0.1); LiₐMn₂G_{b}O₄ (0.90≤a≤1.8, 0.001≤b≤0.1); LiₐMn_{1-g}G_{g}PO₄ (0.90≤a≤1.8, 0≤g≤0.5); Li_{(3-f)}Fe₂(PO₄)₃ (0≤f≤2); and LiₐFePO₄ (0.90≤a≤1.8).

In the above formulas: A is or includes at least Ni, Co, Mn, or a combination thereof; X is or includes at least Al, Ni, Co, Mn, Cr, Fe, Mg, Sr, V, a rare earth element, or a combination thereof; D is or includes at least O, F, S, P, or a combination thereof; G is or includes at least Al, Cr, Mn, Fe, Mg, La, Ce, Sr, V, or a combination thereof; and L1 is or includes at least Mn, Al, or a combination thereof.

A positive electrode for a lithium secondary battery may include a current collector and a positive electrode active material layer formed on the current collector. The positive electrode active material layer may include a positive electrode active material and may further include a binder and/or a conductive material.

The content of the positive electrode active material is in a range of about 90 wt% to about 99.5 wt% on the basis of 100 wt% of the positive electrode active material layer, and the content of the binder and the conductive material is in a range of about 0.5 wt% to about 5 wt%, respectively, on the basis of 100 wt% of the positive electrode active material layer.

The current collector may be or include aluminum (Al) but is not limited thereto.

The negative electrode active material may include a material capable of reversibly intercalating/deintercalating at least one of lithium ions, lithium metal, an alloy of lithium metal, a material capable of being doped and undoped with lithium, or a transition metal oxide.

The material capable of reversibly intercalating/deintercalating lithium ions may be or include a carbon-based negative electrode active material, which may include, for example, at least crystalline carbon, amorphous carbon, or a combination thereof. Examples of the crystalline carbon may include graphite, such as natural graphite or artificial graphite, and examples of the amorphous carbon may include at least one of soft carbon, hard carbon, a pitch carbide, a meso-phase pitch carbide, sintered coke, and the like.

A Si-based negative electrode active material or a Sn-based negative electrode active material may be used as the material capable of being doped and undoped with lithium. The Si-based negative electrode active material may be or include at least silicon, a silicon-carbon composite, SiOx (0 < x < 2), a Si-based alloy, or a combination thereof.

The silicon-carbon composite may be or include a composite of silicon and amorphous carbon. According to one example embodiment, the silicon-carbon composite may be in the form of a silicon particle and amorphous carbon coated on the surface of the silicon particle.

The silicon-carbon composite may further include crystalline carbon. For example, the silicon-carbon composite may include a core including crystalline carbon and silicon particle and an amorphous carbon coating layer on the surface of the core.

A negative electrode for a lithium secondary battery may include a current collector and a negative electrode active material layer disposed on the current collector. The negative electrode active material layer may include a negative electrode active material and may further include a binder and/or a conductive material.

For example, the negative electrode active material layer may include about 90 wt % to about 99 wt % of a negative electrode active material, about 0.5 wt % to about 5 wt % of a binder, and about 0 wt % to about 5 wt % of a conductive material.

**A** non-aqueous binder, an aqueous binder, a dry binder, or a combination thereof may be used as the binder. When an aqueous binder is used as the negative electrode binder, a cellulose-based compound capable of imparting viscosity may be further included.

**As** the negative electrode current collector, at least one of copper foil, nickel foil, stainless steel foil, titanium foil, nickel foam, copper foam, conductive metal-coated polymer substrate, and combinations thereof may be used.

**An** electrolyte for a lithium secondary battery may include a non-aqueous organic solvent and a lithium salt.

The non-aqueous organic solvent may constitute a medium through which ions involved in the electrochemical reaction of the battery can move.

The non-aqueous organic solvent may be or include at least a carbonate-based, an ester-based, an ether-based, a ketone-based, an alcohol-based solvent, an aprotic solvent, and may be used alone or in combination of two or more.

Depending on the type of lithium secondary battery, a separator may be present between the first electrode plate (e.g., the negative electrode) and the second electrode plate (e.g., the positive electrode). As the separator, at least polyethylene, polypropylene, polyvinylidene fluoride, or a multilayer film of two or more layers thereof may be used.

The separator may include a porous substrate and a coating layer including an organic material, an inorganic material, or a combination thereof on one or both surfaces of the porous substrate.

The organic material may include a polyvinylidene fluoride-based polymer or a (meth)acrylic polymer.

The inorganic material may include inorganic particles such as at least one of Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and combinations thereof but is not limited thereto.

The organic material and the inorganic material may be mixed in one coating layer or may be in the form of a coating layer containing an organic material and a coating layer containing an inorganic material that are laminated on each other.

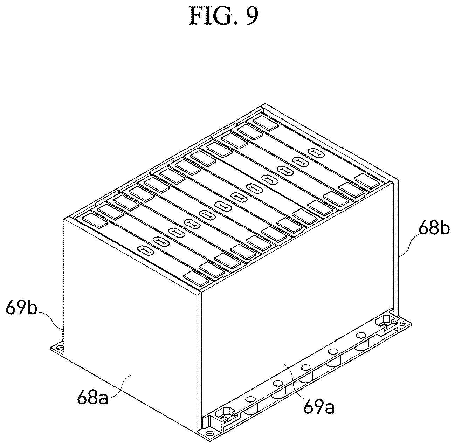

FIG. 9 is an illustration of a secondary battery module in which secondary batteries manufactured according to examples of the present disclosure are arranged. With the increase in secondary battery capacity for driving electric vehicles, and the like, a secondary battery module may be manufactured by arranging and connecting a plurality of secondary battery cells transversely and/or longitudinally. The plurality of secondary batteries may be arranged in a space defined by a pair of facing end plates 68a and 68b and a pair of facing side plates 69a and 69b. The secondary batteries may be designed appropriately in arrangement (direction) and number to obtain desired voltage and current specifications.

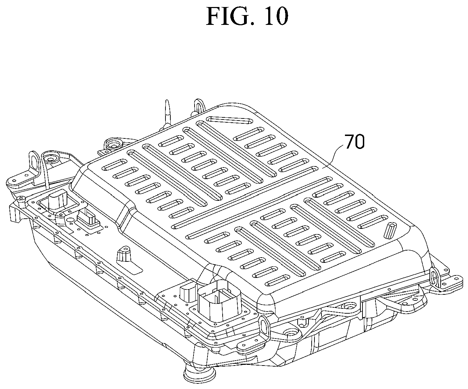

FIG. 10 is an illustration schematically showing the configuration of a battery pack 70 according to example embodiments of the present disclosure. Referring to FIG. 10, a battery pack 70 may include an assembly to which individual batteries are electrically connected, and a pack housing accommodating the same. In the drawings, for convenience of illustration, components including a bus bar, a cooling unit, external terminals for electrically connecting batteries, etc., are not shown.

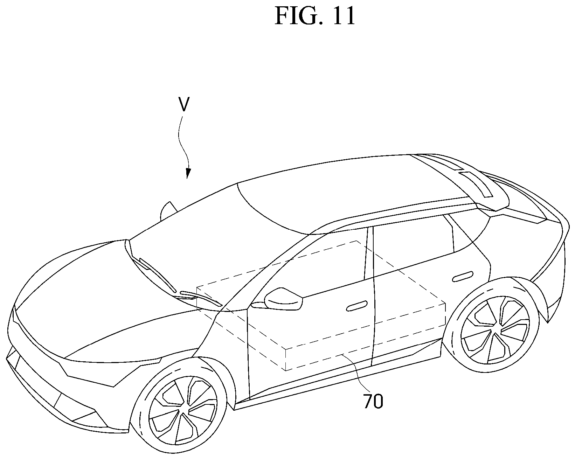

The battery pack 70 may be mounted on (or in) a vehicle. The vehicle may be, for example, an electric vehicle, a hybrid vehicle, a plug-in hybrid vehicle, and the like. The vehicle may be a four-wheeled vehicle or a two-wheeled vehicle but is not limited thereto. FIG. 11 shows a vehicle V which includes the battery pack 70 shown in FIG. 10 on the lower body thereof. The vehicle V may operate by (e.g., may be powered by) receiving power from the battery pack 70.

According to examples of the present disclosure, considering that the typically high investment cost per unit of a density meter makes it relatively costly when installed in various areas of a drying furnace, and installation thereof inside the drying furnace is difficult in terms of size, a difference in an ultrasonic transmission state due to a density difference depending on the drying status of an electrode plate may be monitored through an ultrasonic sensor, and the amount of drying heat inside the drying furnace may be controlled in real-time based on the monitoring results. Accordingly, when an electrode plate composition or a loading level is changed after a job change, or the surrounding air temperature is changed due to seasonal effects, and the like, it is possible to greatly reduce the trials and errors in a process of optimizing electrode plate drying conditions at the beginning of a process, minimize loss of the electrode plate, and improve the productivity of drying furnace equipment and the overall efficiency of an electrode plate drying process.

However, effects that can be achieved through the present disclosure are not limited to the above-described effects, and other technical effects not mentioned will be clearly understood by those skilled in the art from the description of the invention described below.

## Claims

1. A system (1300) for preventing a reuse of a battery monitoring system, BMS, the system (1300) comprising:
a battery monitoring unit (110) configured to monitor specifications of a battery;
a cell replacement determination unit (120) configured to determine whether a cell has been replaced in a battery pack (70) based on results of the monitoring of the specifications of the battery; and
a permanent failure mode entry unit configured to determine whether to enter a permanent failure mode for the battery pack (70) based on the results of the determination of whether the cell has been replaced.

2. The system (1300) as claimed in claim 1, wherein the battery monitoring unit (110) is configured to monitor the specifications of the battery comprising at least any one of the capacity and internal resistance of the battery upon wake-up of the battery pack (70) after shutdown.

3. The system (1300) as claimed in claim 2, wherein the cell replacement determination unit (120) is configured to determine that the cell has been replaced when the capacity of the battery is changed into a maximum reference capacity or more or less than the maximum reference capacity.

4. The system (1300) as claimed in claim 2, wherein the cell replacement determination unit (120) is configured to determine that the cell has been replaced when the internal resistance is changed into maximum reference resistance or more or less than the maximum reference resistance.

5. The system (1300) as claimed in claim 2, wherein the cell replacement determination unit (120) is configured to determine that the cell has been replaced when the capacity of the battery is increased to a reference capacity or more and the internal resistance is increased to reference resistance or more.

6. The system (1300) as claimed in claim 2, wherein the cell replacement determination unit (120) is configured to determine that the cell has been replaced when the capacity of the battery is decreased to a reference capacity or more and the internal resistance is decreased to a reference resistance or more.

7. The system (1300) as claimed in any one of the preceding claims, wherein the cell replacement determination unit (120) is configured to identify an exception condition on the determination of whether the cell has been replaced and prohibits entry into the permanent failure mode, when receiving a communication command related to a reuse of a BMS of the battery pack (70) from a battery pack manufacturer through communication means.

8. A method of preventing a reuse of a battery monitoring system, BMS, the method comprising steps of:
(a) monitoring specifications of a battery;
(b) determining whether a cell has been replaced in a battery pack (70) based on results of the monitoring in the step (a); and
(c) determining to enter a permanent failure mode based on the results of the determination of whether the cell has been replaced.

9. The method as claimed in claim 8, wherein the step (a) comprises monitoring the specifications of the battery comprising at least any one of a capacity and internal resistance of the battery.

10. The method as claimed in claim 8, wherein the step (b) comprises determining that the cell has been replaced when a capacity of the battery, among the specifications of the battery, is changed into a maximum reference capacity or more or less than the maximum reference capacity.

11. The method as claimed in claim 8, wherein the step (b) comprises determining that the cell has been replaced when internal resistance of the battery, among the specifications of the battery, is changed into maximum reference resistance or more or less than the maximum reference resistance.

12. The method as claimed in claim 8, wherein the step (b) comprises determining that the cell has been replaced when a capacity of the battery, among the specifications of the battery, is increased to a reference capacity or more and internal resistance of the battery, among the specifications of the battery, is increased to reference resistance or more.

13. The method as claimed in claim 8, wherein the step (b) comprises determining that the cell has been replaced when a capacity of the battery, among the specifications of the battery, is decreased to a reference capacity or more and internal resistance of the battery, among the specifications of the battery, is decreased to reference resistance or more.

14. The method as claimed in any one of the claims 8 to 13, wherein the step (c) comprises:
identifying whether an exception condition on the determination of whether the cell has been replaced is satisfied based on at least any one of a cycle count and a runtime, and
prohibiting an entry into a permanent failure mode.

15. An apparatus for preventing a reuse of a battery monitoring system, BMS, the apparatus comprising:
an input interface device (1350) configured to receive information on specifications of a battery comprising at least any one of a capacity and internal resistance of the battery;
memory in which a program that determines a fact that a cell has been replaced by an unauthorized institute based on the information on the specifications of the battery has been stored; and
a processor (1310) configured to execute the program,
wherein the processor (1310) determines the fact that the cell has been replaced based on at least any one references comprising a maximum reference capacity, a reference capacity, maximum reference resistance, and reference resistance.
